# EUROPEAN PATENT APPLICATION

(11) **EP 2 660 871 A1**
(43) Date of publication of application: **06.11.2013**
(21) Application number: 11852819.9
(22) Date of filing: 26.12.2011
(51) Int. Cl.: H01L 31/04

(54) **COMPOUND SEMICONDUCTOR THIN FILM SOLAR CELL, AND PROCESS FOR PRODUCTION THEREOF**

(30) Priority: 27.12.2010 JP 2010291278
(71) Applicant: Toppan Printing Co., Ltd., Tokyo 110-0016 (JP)
(72) Inventor: ZHANG, Yiwen, Taito-ku, Tokyo 110-0016 (JP); YAMADA, Akira, Meguro-ku, Tokyo 152-8550 (JP)
(74) Representative: TBK
(86) International application number: PCT/JP2011/080080
(87) International publication number: WO 2012/090938

(57) **Abstract**

A compound semiconductor thin film solar cell is provided, which includes a light-absorbing layer made of a compound semiconductor and a buffer layer formed on the light-absorbing layer. The buffer layer is formed with use of an ink containing nanoparticles each containing at least a metal element and an element of Group 16.

## Description

### Technical Field

The present invention relates to a solar cell comprising a compound semiconductor buffer layer formed using an ink comprising nanoparticles, and a manufacturing method thereof.

### Background Art

Solar cells are devices which convert light energy into electrical energy using a photovoltaic effect. The solar cells are a focus of attention from the point of view of the prevention of global warming, alternative measures for exhausting resources and the like. The solar cells are mainly categorized into a silicon-based type (monocrystal, polycrystal, amorphous or a their composite), a compound semiconductor-based type (CIGS compound, CTZS compound, III-V group compound or II-VI group compound), an organic semiconductor-based type and a dye sensitization-based type.

Of the above-listed types, the compound semiconductor-based solar cell (to be called compound semiconductor thin film solar cell hereinafter) has a high optical absorption coefficient and involves a relatively less number of steps in its manufacturing process, which may result in low-cost production. Therefore, this type of cell is regarded with great expectations as a solar cell of the next generation which plays a part of resource savings and energy resources for suppression of global warming.

For the light-absorbing layer of such a compound semiconductor thin film solar cell, a CIGS thin film of Cu(InGa)Se₂ made of the I-III-VI Group-based type is presently employed, which can achieve a high energy conversion efficiency of over 20%. Alternatively, a Cu₂ZnSn(S,Se)₄ thin film (CZTS thin film) as well is employed, which has a conversion efficiency of over 10%, does not employ a rare metal or creates less environmental loads.

Conventionally, the buffer layer of the above-described type of compound semiconductor thin film solar cell is formed by chemically growing a CdS film, which is a compound semiconductor, from a solution, so that an optimal heterojunction with the light-absorbing layer made of CIGS or CZTS can be obtained. (See U.S. Patent No. 4,611,091 and Thin Solid Films 517 (2009) 2455.)

Here, CdS is a toxic material, and therefore it has a drawback of high environmental load. Under these circumstances, InS-based buffer layer, which does not contain Cd, has been proposed in recent years. (See JP-A 2003-282909 (KOKAI) and Thin Solid Films 517 (2009) 2312-2315.)

However, according to the method discussed in JP-A 2003-282909 (KOKAI), the light-absorbing layer is immersed into an aqueous solution, and thus the buffer layer is formed by the solution growth method. As a result, it is difficult to control the concentration of the solution at constant in mass production, and therefore the conventionally method entails the drawback that the properties of the light-absorbing layers easily vary from one layer to another. Further, due to the great amount of use of the solution, this method also has such problems as high cost for waste disposal and high environmental load.

In the meantime, according to the method discussed in Thin Solid Films 517 (2009) 2312, the buffer layer is formed with use of the spray thermal decomposition method. In this method, therefore, it is necessary to perform spray application for a long time while heating the substrate to a high temperature, which results in such problems as poor production efficiency and high cost.

### Summary of the Invention

### Object to be Achieved by the Invention

An object of the present invention is to provide a solar cell comprising a compound semiconductor buffer layer formed using a low-cost ink for forming a compound semiconductor buffer layer, and a method of manufacturing the solar cell.

### Means for Achieving the Object

According to the first embodiment of the present invention, there is provided a compound semiconductor thin film solar cell including a light-absorbing layer of a compound semiconductor and a buffer layer formed on the light-absorbing layer, characterized in that the buffer layer is formed with use of an ink containing nanoparticles each containing at least a metal element and an element of Group 16.

According to the second embodiment of the present invention, there is provided a method of manufacturing a compound semiconductor thin film solar cell, the method including: forming a light-absorbing layer on an electrode; coating or printing an ink comprising nanoparticles each containing at least a metal element and an element of Group 16 on the light-absorbing layer to form a coating film; and annealing the coating film with a heat treatment to form a buffer layer.

### Brief Description of the Drawings

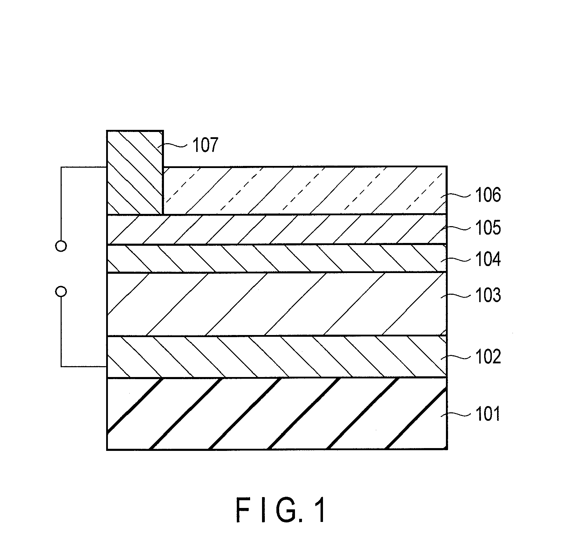

FIG. 1 is a diagram showing a cross section of an overall structure of a compound semiconductor thin film solar cell according to one embodiment of the present invention.

### Mode for Carrying out the Invention

Modes of the present invention will now be described in detail.

The compound semiconductor thin film solar cell according to the first mode of the present invention comprises a light-absorbing layer (light absorption layer, light absorber layer, or light adsorber layer) of a compound semiconductor and a buffer layer formed on the light-absorbing layer, characterized in that the buffer layer is formed with use of an ink comprising nanoparticles each containing at least a metal element and an element of Group 16.

For the compound semiconductor which forms the light-absorbing layer, one having a composition of CuₓIn_{y}Ga_{1-y}Se_{z}S_{2-z} (0 ≤ x ≤ 1, 0 y ≤ 1, 0 z ≤ 2) can be used. Or, one having a composition of Cu₂₋ₓSn_{y}Zn_{2-y}Se_{z}S_{4-z} (0 ≤ x ≤ 2, 0 ≤ y ≤ 2, 0 ≤ z ≤ 4) can be used.

As the nanoparticles, a material containing In and S can be used. Meanwhile, the molar ratio of In/S of the nanoparticles can be set to 1/8 to 2. Further, for the nanoparticles, In₂S₃ can be used. Furthermore, for the nanoparticles, those having an average particle diameter of 1 nm or larger and 200 nm or smaller can be used.

The ink may contain a binder comprising S atom. As the binder which contains the S atom, those which are denoted by the following chemical formula can be used. 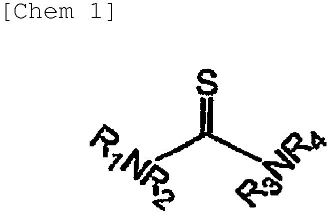 (where R₁, R₂, R₃ and R₄ each independently represents a hydrogen atom or an alkyl group having 1 to 10 carbons.)

The method of manufacturing a solar cell according to the second embodiment of the present invention, includes: forming a light-absorbing layer on an electrode; applying an ink including nanoparticles each containing at least a metal element and an element of Group 16 or printing with the ink, thereby forming a coating film; and subjecting the coating film to a heat treatment, thereby forming a buffer layer.

With the first and second embodiments of the present invention described above, a compound semiconductor thin film solar cell having a high photoelectric conversion efficiency and less environmental loads can be provided at a low cost.

The compound semiconductor thin film solar cell according to the first embodiment of the present invention and the method of manufacturing the compound semiconductor thin film solar cell according to the second aspect will now be described in more detail.

A base material on which a compound semiconductor thin film solar cell of this embodiment is formed may be any type of a plate-like member as long as a layer can be formed evenly thereon by a coating or printing method. Specific examples of the material are general ones such as glass, metals such as iron, copper and aluminum, plastics such as PET and polyimide, but it is preferable that materials having excellent heat resistance property to be capable of withstanding the heat during, in particular, drying and crystallization.

These materials can be used in layers. In particular, the base material made of stainless steel or polyimide has a high bending property and also a high heat resistance property, and it is suitable and particularly preferable for the production by roll-to-roll process.

As the light-absorbing layer made of the compound semiconductor, for the compound semiconductor thin film solar cell of this embodiment, those having the compositions of CuₓIn_{y}Ga_{1-y}Se_{z}S_{2-z} (0 ≤ x ≤ 1, 0 ≤ y ≤ 1, 0 ≤ z ≤ 2), Cu₂₋ₓSn_{y}Zn_{2-y}Se_{z}S_{4-z} (0 ≤ x ≤ 2, 0 ≤ y ≤ 2, 0 ≤ z ≤ 4) and AgₓIn_{y}Ga_{1-y}Se_{z}S_{2-z} (0 ≤ x ≤ 1, 0 ≤ y ≤ 1, 0 ≤ z ≤ 2) can be used. Alternatively, general compound semiconductors such as CuInTe₂, Cu₂Zn(Sn₁₋ₓGeₓ)S₄ can be employed as well. In these materials, the band gap can be varied by adjusting the amount of each element.

In the compound semiconductor thin film solar cell of this embodiment, the light-absorbing layer can be formed by either a vacuum process or non-vacuum process. Examples of the vacuum process are the spattering method and the vapor deposition method, whereas examples of the non-vacuum process are the hydrazine application method and the thermospray method. The non-vacuum processes have the advantages of a high throughput, a high material utilization rate and a low cost.

The buffer layer of the compound semiconductor thin film solar cell of this embodiment is formed by applying an ink comprising nanoparticles, or printing with the ink. The nanoparticle application method has the advantages that it involves a simpler step as compared to the chemical deposition method or spray thermal decomposition method, and the buffer layer can be formed in a short period of time. Further, such an application method can achieve a less unevenness within a plane even for a large area, and also cope with such manufacturing methods having a high productivity, as the roll-to-roll process.

The nanoparticles used to form the buffer layer of the compound semiconductor thin film solar cell of this embodiment is a metal compound containing at least a metal element and a Group 16 element of the periodic table. In particular, a type having an excellent light transmittance in a wavelength used for photoelectric conversion is desirable for use. Examples of the metal element are Mg, Zn, Cd and In, whereas examples of the Group 16 element are chalcogen elements such as O, S and Se.

For the buffer layer, the nanoparticles made from the metal compound of these elements are used. More specifically, for example, CdS, ZnS, ZnOH, InO₂, or a mixture of these can be used. Of these, ZnS, ZnSe and InS are preferable. It is particularly preferable that the buffer layer made of a compound of In and S should be used, and more specifically, a preferable example thereof is In₂S₃. The buffer layer, when made from In element and S element, can exhibit an excellent p-n heterojunction to the light-absorbing layer, and further, since Cd element is not used, the environmental loads are less.

The average particle diameter of the nanoparticles used for the compound semiconductor thin film solar cell of this embodiment is preferable in a range of 1 nm or more and 200 nm or less. When the average particle diameter exceeds 200 nm, it is likely that a gap is created in the compound semiconductor film in the heat treating step, which results in the lowering of the photoelectric conversion efficiency. On the other hand, when the average particle diameter is less than 1 nm, it is likely that fine particles are agglomerated, which makes it difficult to prepare the ink. It should be noted that the average particle diameter of the nanoparticles is more preferably in a range of 5 nm or more and 100 nm or less.

Here, the average particle diameter was obtained by directly measuring the diameters of 100 or more particles appearing on a plurality of electron microscope photographs taken with use of an electron microscope (JSM-7001F of JEOL), and taking the average of the measured diameters.

The molar ratio between In element and S element in the composition of In and S which constitutes each of the nanoparticles is preferably as follows: In/S = 1/8 to 2. When the In/S ratio is less than 1/8, the light transmittance of the buffer layer becomes low and thus the conversion efficiency of the solar cell decreases. On the other hand, when the In/S ratio is larger than 2, the crystallinity of the InS layer degrades, and thus an excellent junction with the light-absorbing layer cannot be obtained. In particular, the ratio is most preferably: In/S = 2/3.

In the compound semiconductor thin film solar cell of this embodiment, the ink made from the nanoparticles for forming the buffer layer may contain a binder comprising S atom. The use of a binder prevents the agglomeration of particles during the application step, and as the gaps between particles are filled with the binder, the gaps of the buffer layer after the crystallization can be decreased. Further, due to the surface smoothing effect of the binder, the surface is smoothed, and the number of defects can be decreased.

As the binder which contains the S atom, those which are expressed by the below specified chemical formula can be used. 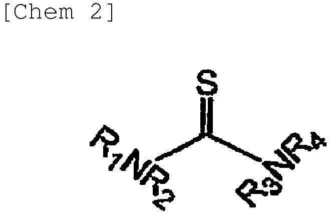 (where R₁, R₂, R₃ and R₄ each independently represents a hydrogen atom or an alkyl group having 1 to 10 carbons.)

The binder which contains a thiourea group is easily dissolvable to organic solvents, and therefore it has the merit that the binder solution can be easily prepared. Further, the thiourea group is easily thermally decomposable, and therefore it has the merit that it does not easily remain in the layer after the crystallization.

In the compound semiconductor thin film solar cell of this embodiment, the ink for forming the buffer layer can be prepared by dispersing the binder comprising S atom and the metal compound particles into an organic solvent.

The organic solvent used for the ink for forming the buffer layer is not particularly limited, but examples thereof are alcohols, ethers, esters, aliphatic hydrocarbons, aliphatic cyclic hydrocarbons and aromatic hydrocarbons. Preferable examples of the organic solvent are alcohols having less than 10 carbons, such as methanol, ethanol and butanol, diethylether, pentane, hexane, cyclohexane and toluene. Of these, particularly preferable organic solvents are methanol, pyridine and toluene.

The ink used in this embodiment may be blended with a dispersant so that the binder containing the S atom and In₂S₃ particles are dispersed in the organic solvent efficiently. Examples of the dispersant are thiols, selenols and alcohols having 10 or more carbons.

In the meantime, the ink used in this embodiment can be blended with a binder such as a silica binder so as to obtain a compound semiconductor thin film having a high strength. It should be noted here that the concentration of the particles in the organic solvent is not particularly limited, but it is usually 1 to 20% by weight.

In the compound semiconductor thin film solar cell of this embodiment, the buffer layer can be formed by applying the above-described ink for forming the buffer layer on a base material or printing with the ink, and drying the ink to remove the organic solvent, followed by a heat treatment.

Examples of the application method are the doctor method, spin-coating method, slit-coating method and spray method, whereas examples of the printing method are the gravure printing method and screen printing method.

The thickness of the coating film formed by the application or printing should preferably be such that the thickness of the compound semiconductor thin film after the drying and heat treatment becomes 20 nm to 300 nm, for example, about 50 nm.

The heat treatment can be carried out by annealing with a heating oven, as well as by rapid thermal anneal (RTA).

The heat treatment temperature is preferably 150°C or higher, which is a temperature necessary for the crystallization of the compound semiconductor. Here, in the case where a glass substrate is used as the substrate, the heat treatment temperature is preferably be 600°C or lower, or particularly, 550°C or lower, with which the glass substrate can withstand. Most preferably, the temperature is 200°C to 300°C.

The specific structure of the compound semiconductor thin film solar cell according to this embodiment will now be described with reference to FIG. 1.

FIG. 1 is a diagram showing a cross section of an overall structure of a compound semiconductor thin film solar cell according to one embodiment of the present invention. In the solar cell shown in FIG. 1, a back electrode 102 is formed on a substrate 101. As the substrate 101, soda lime glass, metal plate, plastic film or the like can be used. As the back electrode 102, a metal such as molybdenum (Mo), nickel (Ni) or copper (Cu) can be used.

A light-absorbing layer 103 of a compound semiconductor is formed on the back electrode 102 by the triple step vapor deposition method.

A buffer layer 104 is formed on the light-absorbing layer 103. More specifically, the buffer layer 104 is formed by applying the above-described ink on the light-absorbing layer 103, and drying the ink, followed by the heat treatment.

An i layer 105 and an n layer 106 are formed consecutively in this order on the buffer layer. As the i layer 105, a conventionally known metal oxide such as ZnO can be used. Meanwhile, as the n layer 106, a conventionally known ZnO material to which Al, Ga, B or the like is added can be used. Then, a front electrode 107 is formed on the n layer 106, and thus a solar cell is completed. As the front electrode 107, a conventionally known metal Al or Ag can be used.

Although it is not illustrated in the figure, it is alternatively possible to provide an antireflection film on the n layer 106, for the purpose of suppressing the reflection of light and promoting the light-absorbing layer to absorb more light. The material of the antireflection film is not particularly limited, but, for example, magnesium fluoride (MgF₂) can be used. An appropriate thickness of the antireflection film is about 100 nm.

The solar cell according to this embodiment has the above-described structure. That is, an ink in which nanoparticles are dispersed is applied or subjected to printing, and then dried and heat-treated, thereby forming a buffer layer. With this structure, the evenness within a plane can be improved even for a large area as compared to the conventional methods. Further, the steps are simple and therefore the cell can be manufactured at a lower cost.

### EXAMPLES

It should be noted that the present invention will now be described in detail based on examples, but the technical scope of the present invention is not limited to the following examples.

### Example 1

### (Preparation of Ink)

InI₃ dissolved into pyridine was mixed into a solution of methanol in which Na₂S was dissolved. The mixture solution was adjusted such that the molar ratio between InI₃ and Na₂S was 2 : 3. After the mixture, the solution was made to react in an inert gas atmosphere at 0°C, and thus In₂S₃ nanoparticles were generated. The thus obtained liquid was filtrated, and then the filtered material was washed with methanol. After that, the resultant was dispersed in pyridine such as to have a solid content of 5%, and thus an ink was obtained.

### (Formation of Back Electrode 102)

A 0.6 µm-thick Mo layer was formed on a soda lime glass (101) by the spattering method.

### (Formation of CIGS Layer 103)

Elements Cu, In, Ga and Se were deposited on the Mo substrate by the triple step vapor deposition method, and thus a CuIn_{0.8}Ga_{0.2}Se₂ layer having a thickness of 2 µm was formed.

### (Formation of Buffer Layer 104)

The above-described ink is applied on CuIn_{0.8}Ga_{0.2}Se₂ layer by the spray method and then heated at 275°C for 10 minutes. Thus, a buffer layer 104 having a thickness of 50 nm was formed.

### (Formation of i Layer 105)

Using diethyl zinc and water as raw materials, a ZnO layer having a thickness of 50 nm was deposited on the buffer layer by the MOCVD method.

### (Formation of n Layer 106)

Using diethyl zinc, water and diborane as raw materials, a ZnO:B layer having a thickness of 1 µm was formed on the i layer by the MOCVD method.

### (Formation of Front Electrode 107)

A 0.3 µm-thick Al electrode was formed on the ZnO:B layer of the n layer by the vapor deposition method. Thus, a CIGS solar cell was obtained.

### Comparative Example 1

As in Example 1 discussed above, a 0.6 µm-thick Mo layer was formed on a soda lime glass by the spattering method, and then a 2 µm-thick CIGS layer was formed by the vapor deposition method.

Next, cadmium sulfide (CdSO₄), thiourea (NH₂CSH₂) and ammonium water (NH₄OH) were added to a mixture aqueous solution at molar concentrations of 0.0015M, 0.075M of and 1.5M, respectively, at 70°C, and the CIGS layer was immersed in the solution. Then, on the light-absorbing layer 103, a buffer layer 104 of CdS having a thickness of 50 nm was formed.

Lastly, the ZnO layer, ZnO:B layer and Al electrode were formed consecutively in this order on the buffer layer as in Example 1. Thus, a CIGS solar cell was obtained.

### Comparative Example 2

As in Example 1 discussed above, a 0.6 µm-thick Mo layer was formed on a soda lime glass by the spattering method, and then a 2 µm-thick CIGS layer was formed by the vapor deposition method.

Next, without forming a buffer layer 104, the ZnO layer, ZnO:B layer and Al electrode were formed consecutively in this order on the CIGS layer. Thus, a CIGS solar cell was obtained.

The solar cells of Example 1 and Comparative Examples 1 and 2 discussed above, were evaluated by a reference solar radiation simulator (light intensity: 100 mW/cm², air mass: 1.5). The results are shown in TABLE 1 below.
[TABLE 1]

**TABLE 1**

| Items | Example 1 | Comparative Example 1 | Comparative Example 2 |
|---|---|---|---|
| Photoelectric conversion efficiency | 11.7% | 12.1% | 3.7% |

As shown in TABLE 1 above, with use of a buffer layer comprising In₂S₃ particles in Example 1, a photoelectric conversion efficiency equivalent to that of the case where a CdS buffer layer is used was observed. Further, it was also observed that the conversion efficiency was high as compared to that of Comparative Example 2 which was formed without a buffer layer.

### Example 2

### (Preparation of Ink)

InI₃ dissolved into pyridine was mixed into a solution of methanol in which Na₂S was dissolved. The mixture solution was adjusted such that the molar ratio between InI₃ and Na₂S was 2 : 3. After the mixture, the solution was made to react in an inert gas atmosphere at 0°C, and thus In₂S₃ nanoparticles were generated. The thus obtained liquid was filtrated, and then the filtered material was washed with methanol. After that, the resultant was dispersed in pyridine such as to have a solid content of 5%, and thus an ink was obtained.

### (Formation of Back Electrode 102)

A 0.6 µm-thick Mo layer was formed on a soda lime glass (101) by the spattering method.

### (Formation of CZTS Layer 103)

SnS, Cu and ZnS were spattered on the Mo layer, and then annealed in an nitrogen atmosphere containing 20%H₂S for 3 hours at 550°C, and thus a Cu₂ZnSnS₄ layer having a thickness of 2 µm was formed.

### (Formation of Buffer Layer 104)

The above-described ink is applied on the Cu₂ZnSnS₄ layer by the spray method and then heated at 275°C for 10 minutes. Thus, a buffer layer 104 having a thickness of 50 nm was formed.

### (Formation of i Layer 105)

Using diethyl zinc and water as raw materials, a ZnO layer having a thickness of 50 nm was deposited on the buffer layer by the MOCVD method.

### (Formation of n Layer 106)

Using From diethyl zinc, water and diborane as raw materials, a ZnO:B layer having a thickness of 1 µm was formed on the i layer by the MOCVD method.

### (Formation of Front Electrode 107)

A 0.3 µm-thick Al electrode was formed on the ZnO:B layer of the n layer by the vapor deposition method. Thus, a CZTS solar cell was obtained.

### Comparative Example 3

As in Example 2 discussed above, a 0.6 µm-thick Mo layer was formed on a soda lime glass by the spattering method, and then a 2 µm-thick CZTS layer was formed by the spattering method.

Next, cadmium sulfide (CdSO₄), thiourea (NH₂CSH₂) and ammonium water (NH₄OH) were added to a mixture aqueous solution at molar concentrations of 0.0015M, 0.075M of and 1.5M, respectively, at 70°C, and the CZTS layer was immersed in the solution. Then, on the light-absorbing layer 103, a buffer layer 104 of CdS having a thickness of 50 nm was formed.

Lastly, the ZnO layer, ZnO:B layer and Al electrode were formed consecutively in this order on the buffer layer as in Example 2. Thus, a CZTS solar cell was obtained.

### Comparative Example 4

As in Example 2 discussed above, a 0.6 µm-thick Mo layer was formed on a soda lime glass by the spattering method, and then a 2 µm-thick CZTS layer was formed by the spattering method.

Next, without forming a buffer layer, the ZnO layer, ZnO:B layer and Al electrode were formed consecutively in this order on the CZTS layer. Thus, a CZTS solar cell was obtained.

The solar cells of Example 2 and Comparative Examples 3 and 4 discussed above, were evaluated by a reference solar radiation simulator (light intensity: 100 mW/cm², air mass: 1.5). The results are shown in TABLE 2 below.
[TABLE 2]

**TABLE 2**

| Items | Example 2 | Comparative Example 3 | Comparative Example 4 |
|---|---|---|---|
| Photoelectric conversion efficiency | 4.3% | 4.6% | 1.3% |

As shown in TABLE 2 above, with use of a buffer layer comprising In₂S₃ particles in Example 2, a photoelectric conversion efficiency equivalent to that of the case where a CdS buffer layer is used was observed. Further, it was also observed that the conversion efficiency was high as compared to that of Comparative Example 4 which was formed without a buffer layer.

## Claims

1. A compound semiconductor thin film solar cell comprising:
a light-absorbing layer made of a compound semiconductor; and
a buffer layer formed on the light-absorbing layer,
**characterized in that** the buffer layer is formed with use of an ink comprising nanoparticles each containing at least a metal element and an element of Group 16.

2. The solar cell of claim 1, **characterized in that** a composition of the compound semiconductor is CuₓIn_{y}Ga_{1-y}Se_{z}S_{2-z} (0 ≤ x ≤ 1, 0 ≤ y ≤ 1, 0 ≤ z ≤ 2).

3. The solar cell of claim 1, **characterized in that** a composition of the compound semiconductor is Cu₂₋ₓSn_{y}Zn_{2-y}Se_{z}S_{4-z} (0 ≤ x ≤ 2, 0 ≤ y ≤ 2, 0 ≤ z ≤ 4).

4. The solar cell of one of claims 1 to 3, **characterized in that** the nanoparticles each contain In and S.

5. The solar cell of claim 4, **characterized in that** the nanoparticles each have an In/S molar ratio of 1/8 to 2.

6. The solar cell of one of claims 1 to 3, **characterized in that** the nanoparticles are made of In₂S₃.

7. The solar cell of one of claims 1 to 3, **characterized in that** the nanoparticles have an average particle diameter of 1 nm or more but 200 nm or less.

8. The solar cell of one of claims 1 to 3, **characterized in that** the ink comprises a binder containing S atom.

9. The solar cell of claim 8, **characterized in that** the binder containing S atom is denoted by a chemical formula provided below: 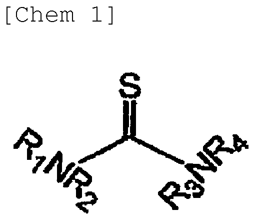 where R₁, R₂, R₃ and R₄ each independently represents a hydrogen atom or an alkyl group having 1 to 10 carbons.

10. A compound semiconductor thin film solar cell **characterized by** comprising a buffer layer formed by coating or printing the ink described in one of claims 1 to 3 followed by a heat treatment.

11. A method for manufacturing a compound semiconductor thin film solar cell, the method **characterized by** comprising:
forming a light-absorbing layer on an electrode;
coating or printing an ink comprising nanoparticles each containing at least a metal element and an element of Group 16 on the light-absorbing layer to form a coating film; and
annealing the coating film with a heat treatment to form a buffer layer.
